Europäisches Patentamt

European Patent Office

Office européen des brevets

(11) Publication number: **0 267 587**
**A2**

# (12) EUROPEAN PATENT APPLICATION

(21) Application number: 87116603.9

(51) Int. Cl.⁴: **G11C 29/00**

(22) Date of filing: **10.11.87**

(30) Priority: **10.11.86 JP 268221/86**

(43) Date of publication of application:
**18.05.88 Bulletin 88/20**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Fujii, Takeo c/o NEC Corporation**
**33-1, Shiba 5-chome**
**Minato-ku Tokyo(JP)**

(74) Representative: **Glawe, Delfs, Moll & Partner**
**Patentanwälte**
**Rothenbaumchaussee 58 Postfach 2570**
**D-2000 Hamburg 13(DE)**

(54) Semiconductor memory device with improved cell arrangement.

(57) A semiconductor memory device with an improved arrangement of memory cells suitable for test is disclosed. The memory device comprises a plurality of memory cell blocks, a plurality of selection circuits each provided for each of the memory cells and operatively selecting one memory cell in the memory cell block and a control circuit coupled to the plurality of selection circuits for applying a data signal to only one of the selection circuits in a normal operation mode and to all the selection circuits in a test mode.

FIG. 2

EP 0 267 587 A2

## SEMICONDUCTOR MEMORY DEVICE WITH IMPROVED CELL ARRANGEMENT

### BACKGROUND OF THE INVENTION:

The present invention relates to a semiconductor memory device formed on a semiconductor substrate, and more particularly to a dynamic type semiconductor device having a test circuit.

Memory capacity of semiconductor memories have been increasing remarkably, and 1 Mega-bit memories are commercially available and there has been made announcements of developments of 4 Mega-bit memories. Accompanied by the the increase in the memory capacity, test time for testing such large capacity of memories has been also increased. For example, the test time for a 1 Mega-bit memory is four times the test time for 256 K-bit memory for the simplest case.

Furthermore, in the memories having a large capacity, there are additional factors to be checked or tested, as compared to the test for the memories having small memory capacity. For example, patterns and arrangements of elements and wirings are very dense in the 1 Mega-bit memories as compared to the 256 K-bit memories and therefore stray effects between the respective elements and wirings are very remarkable in the 1 Mega-bit memories. Accordingly, a test pattern for the 1 Mega-bit memories has become complicated and lengthy for checking the above stray effects.

Thus, cost in testing the memories has become large in accordance with the increase in the memory capacities.

Under the above circumstances, it has been proposed to provide the memory with a test circuit. The test circuit writes the same data to a plurality of memory locations, i.e. memory cells simultaneously and thereafter reads data stored in the plurality of memory locations simultaneously in a test mode. Thus, a test time for the test of simple read-write test for the respective memory locations is effectively reduced.

For example, in performing read-write test for the memory of 1 Mega words x 1 bit structure, the test circuit writes the same data to four memory locations and reads data stored in the four memory locations simultaneously so that the above memory is treated as a memory of 256 K-words x 4 bits structure.

Thus, the above testing scheme is advantageous in reducing the test time.

However, the above test by the test circuit does not evaluate the function of the memory accurately because the same data is written into a plurality of memory locations in parallel in the above test while the data is written into only one memory location in a normal operation mode. Namely, a plurality of memory locations show the same behaviour in the test mode and such behaviour mutually affects from each other among the memory locations subjected to the test through stray coupling. Therefore, operational margins in the respective memory locations obtained through the above test seems better than the practical operational margin in the normal operational mode.

Accordingly, the reliability of the test is insufficient to evaluate the memory.

### SUMMARY OF THE INVENTION

It is an object of the present invention to provide a memory device having improved memory cell arrangement which improves the reliability in testing.

The semiconductor memory device according to the present invention comprises a plurality of memory cell blocks each having a plurality of memory cells, a plurality of selection circuits each provided for each of the memory cell blocks and operatively selecting only one memory cell in the associated memory cell block, a data input circuit for operatively generating a write data in response to an input data signal and a control circuit coupled between the data input circuit and the plurality of selection circuits for establish a signal path between one of the selection circuits and the data input circuit in a normal operation mode and establishing signal paths between the data input circuit and a plurality of the selection circuits in a test mode.

According to the present invention, a plurality of memory cells are not selected for access in each memory cell block in the test mode, but only one memory cell is selected in each memory cell block. Therefore, condition of accessing the memory cell in the test mode in the respective memory cell blocks is substantially the same as that in the selected memory cell block in the normal operation mode.

Accordingly, the result of the test of the memory device of the invention accurately evaluates the practical memory characteristics.

BRIEF DESCRIPTION OF DRAWINGS

Fig. 1 is a schematic block diagram of a memory device according to a prior art;

Fig. 2 is a schematic block diagram of a memory device according to a first embodiment of the present invention;

Fig. 3 is a schematic circuit diagram of an I/O select circuit;

Fig. 4 is a schematic block diagram of a memory device according to a second embodiment of the invention; and

Fig. 5 is a schematic block diagram of a memory device according to a third embodiment of the present invention:

DETAILED DESCRIPTION OF THE INVENTION

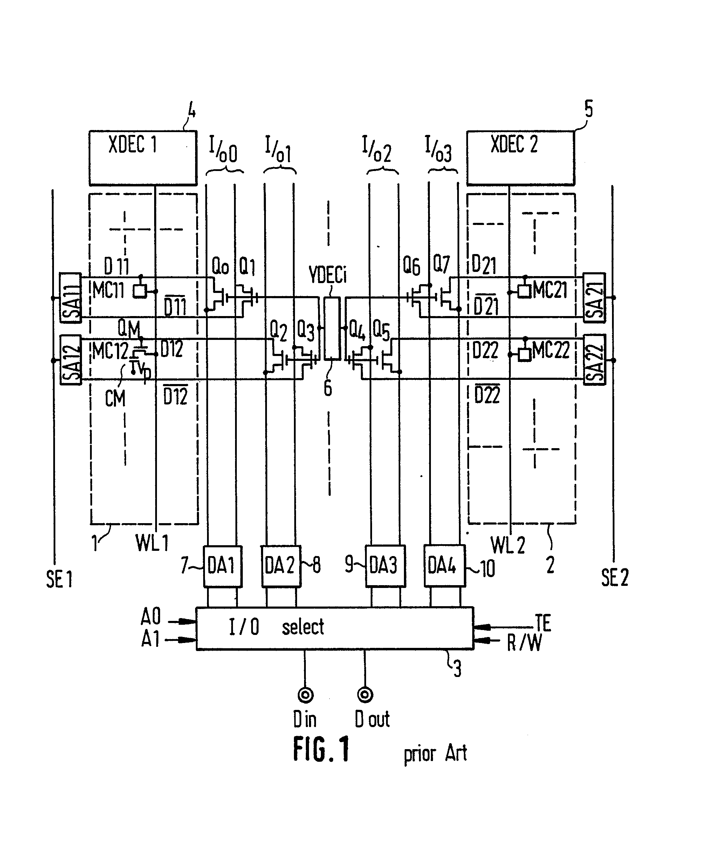

Referring to Fig. 1, a major part of a semiconductor memory device according to a prior art will be explained.

A plurality of one-transistor type memory cells are divided into two memory cell blocks 1 and 2. In the memory cell block 1, a plurality of word lines WL1 are arranged in rows and a plurality pairs of bit lines D11, $\overline{D11}$; D12, $\overline{D12}$ ... are arranged in columns. Memory cells such as MC11 and MC12 are arranged for the respective intersections of the word lines and bit line pairs in a known way and each of the memory cells includes a memory cell transistor $Q_M$ and a storage capacitor $C_M$. One plates connected to a potential Vp which may be a power voltage Vcc, 1/2 Vcc or a ground potential, of the storage capacitors $C_M$ in the block 1 are formed of a polycrystalline silicon commonly to form a common memory cell plate. A row decoder (X DEC 1) 4 is used to select one of the word lines WL1 in the block 1 and a plurality of sense amplifiers SA11, SA12 enabled by a signal SE1 ... are provided for the respective bit lines pairs, D11, $\overline{D11}$; D12, $\overline{D12}$ ... . In the memory cell block 2, word lines WL2, a plurality pairs of bit lines D21, $\overline{D21}$; D22, $\overline{D22}$ ... and a plurality of memory cells MC21, MC22 ... are arranged in the same way as the block 1. One plates connected to Vp of the storage capacitors $C_M$ in the block 1 are commonly formed of a polycrystalline silicon to form another common memory cell plate. A row decoder (X DEC 2) 5 is used to drive one of the word lines WL2 in the block 2 and a plurality of sense amplifiers SA21, SA22 ... amplify signal differences in the respective bit line pairs in response to an active level of a control signal SE2, in a known way. Two pairs of bus lines I/O 0 and I/O 1 are provided for the block 1 and each odd number of bit line pair such as D11 and $\overline{D11}$ are connected to the bus line pair I/O 0 via column selection transistors $Q_0$

and $Q_1$ which are controlled by an output of one of a column decoder (Y DEC) 6 and each even number of bit line pair, such as D12 and $\overline{D12}$ are connected to the bus line pair I/O 1 through a pair of column selection transistors $Q_2$ and $Q_3$. Similarly, the odd number of bit line pair D21, $\overline{D21}$ in the block 2 are connected to a bus line pair I/O 3 via column selection transistors $Q_6$ and $Q_7$ while the even number of bit line pair D22, $\overline{D22}$ are connected to a bus line pair I/O 2 via a pair of column selection transistors $Q_4$ and $Q_5$.

Thus, two pairs of bit lines in the block 1 and two pairs of bit lines in the block 2 are selectively connected to the bus line pairs I/O 0, I/O 1 and I/O 2, I/O 3 respectively.

Data amplifiers DA1 - DA4 are provided for the bus line pair I/O 0 - I/O 3 respectively, but the amplifiers DA1 - DA4 are not essential in memory operation, and may be deleted.

An I/O select circuit 3 receives two bits of address signals A0 and A1, a read-write control signal R/W and a test signal TE, and in a normal operation mode in which the signal TE is at an inactive (e.g. ground) level, the circuit 3 produces information from a selected one bus line pair e.g. I/O 1 to a data output Dout in a read state (e.g. R/W = 1) and transmits information at a data input terminal $D_{in}$ to a selected one bus line pair in a write state (e.g. R/W = 0). Thus, the circuit 3 performs the selection of 1 of 4 in the normal operation mode.

While in a test mode in which the test signal TE assumes an active (e.g. high) level, the circuit 3 determines the states of the bus line pairs I/O 0 - I/O 3 simultaneously based on the state of the input terminal $D_{in}$ and the same data applied to the input terminal D $_{in}$ are generated on the four bus line pairs I/O 0 - I/O 3 and then written into two memory cells in the block 1 via two pairs of column selection transistors and into two memory cells in the block 2 via two pairs of column selection transistors at one time in the write state.

Thus, by utilizing the above test mode, writing time of data to the memory cells in the blocks 1 and 2 is effectively shortened to one quarter as compared to writing in the normal operation mode.

In the read state of the test mode, signals read out to the bus line pairs I/O 0 - I/O 3 are compared and a comparison result is produced at the output terminal $D_{out}$ or simply subjected to a wired OR logic at $D_{out}$.

In the above memory, there are capacitive couplings among the bit lines in the same memory block and the capacitor plate connected to Vp is shared by a plurality of memory cells in the same block.

Accordingly, the condition of writing data to one memory cell such as MC11 in the block 1 in the normal operation mode is completely different from the condition of writing the same data to two memory cells such as MC11 and MC12 in the test mode. For example, in the normal operation mode, only one pair of bit lines are subjected to change in potential with other bit lines unchanged in the respective blocks, and therefore, a change in potentials at the above one pair of bit lines are relatively suppressed through capacitive couplings among bit lines in the respective blocks. While in the test mode, two pairs of bit lines are subjected to the same change in potentials and therefore the potential changes in the respective above bit lines are relatively large.

Thus, the behaviour of writing in the test mode does not accurately simulate the behaviour of the normal operating mode. Therefore the operational margin measured in the test mode is frequently is not used for the practical operational margin.

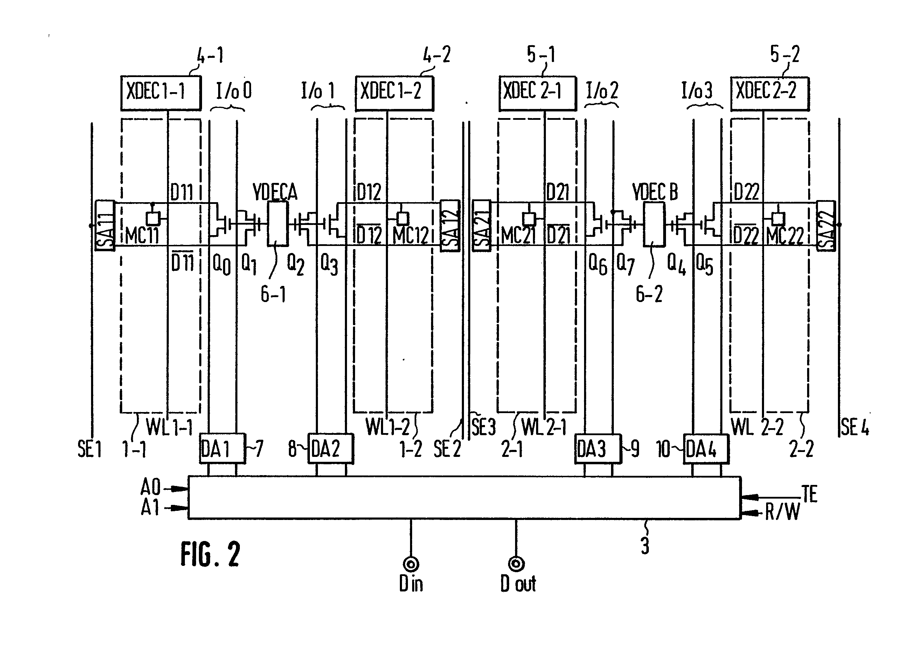

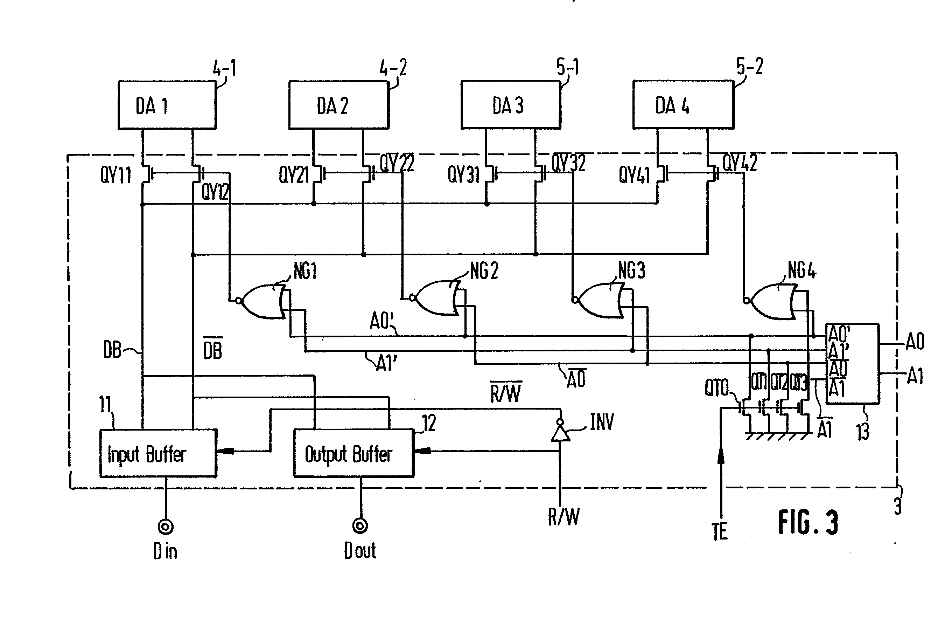

Referring to Figs. 2 and 3, a memory device according to one embodiment of the present invention is explained.

In Figs. 2 and 3, the portions or elements corresponding to those in Fig. 1 are denoted by the same or similar references.

As is shown in Fig. 2, the odd number of bit line pairs (D11, $\overline{\text{D11}}$) and the even number of bit line pairs (D12, $\overline{\text{D12}}$) in the block 1 in Fig. 1 are arranged in different memory blocks 1-1 and 1-2, respectively. Also, the odd and even number of bit line pairs D21, $\overline{\text{D21}}$, D22, $\overline{\text{D22}}$ in the block 1 in Fig. 1 are arranged in different two blocks 2-1 and 2-2. In place of the column decoder 6 of Fig. 1, two column decoders (Y DEC A, Y DEC B) 6-1 and 6-2 are provided for selecting the bit line pairs in the blocks 1-1 and 1-2, and 2-1 and 2-2, respectively. It is also possible to control the transistors $Q_0$ to $Q_7$ by the output of a single column decoder such as one 6 in Fig. 1 in place of two separate decoders 6-1 and 6-2 which simultaneously enable transistors $Q_0$ -$Q_3$ and $Q_4$ -$Q_7$ respectively.

According to the memory device of Fig. 2, the four bit line pairs which are selected simultaneously in the test mode, are located in different four memory blocks 1-1 to 2-2, respectively. In other words, in each of the blocks 1-1, 1-2, 2-1 and 2-2, only one pair of bit lines are subjected to writing of data thereto in the test mode. This condition in the test mode is very similar or equal to that in the normal operation mode.

Namely, in both in the test mode and the normal operation mode, writing of data is performed on only one bit line pair with other bit lines pairs unchanged in potential in each of block and change in potential of the bit line pair subjected to writing operation is relatively suppressed to a small value due to capacitive couplings among the bit lines in the same block.

Only difference between the test mode and the normal operation mode resides in that write operation is performed in four blocks 1-1 to 2-2 in parallel in the test mode while write operation is performed in only one selected block in the normal operation mode.

In the respective blocks 1-1 to 2-2, the memory cells are of one transistor type composed of the transistor $Q_M$ and the storage capacitor $C_M$ as shown in Fig. 1 and the capacitor plates connected to Vp of the capacitors $C_M$ are commonly formed of a single plate of polycrystalline silicon in each of blocks 1-1 to 2-2.

One example of the I/O select circuit 3 is shown in Fig. 3.

The select circuit 3 includes a pair of data bus lines DB and $\overline{\text{DB}}$, and four pairs of transfer gate transistors $QY_{11}$, $QY_{12}$; $QY_{21}$, $QY_{22}$; $QY_{31}$, $QY_{32}$; $QY_{41}$, $QY_{42}$ coupled between the data bus lines DB and $\overline{\text{DB}}$ and four data amplifiers 4-1, 4-2, 5-1 and 5-2, respectively. The data bus lines DB and $\overline{\text{DB}}$ are connected to a pair of output of an input buffer 11 and a pair of input of an output buffer 12. The output buffer 12 is enabled in a read state in which the control signal R/W is high while the input buffer 11 is enabled in a write state in which the signal R/W is low in level and its inverted signal $\overline{\text{R/W}}$ by an inverter INV is high in level. An address inverter 13 receives two bits of address signals A0 and A1 and generates their true and complementary signals A0', $\overline{\text{A0}}$, A1' and $\overline{\text{A1}}$ in a known way. Each of four NOR gates NG1 - NG4 receives two of the four outputs of the inverters 13 in a predetermined combination to achieve a decoder function for selecting one pair of transfer gate transistors. Clamp transistors $QT_0$ -$QT_3$ are coupled between the respective outputs A0', A1', $\overline{\text{A0}}$ and $\overline{\text{A1}}$ and the ground potential.

In the normal operation mode, the test signal TE is at a low inactive level and the transistors $QT_0$ -$QT_3$ are non-conductive. Therefore, according to the contents of the address signals A0 and A1, one (e.g. NG1) of the NOR gates NG1 - NG4 is made active and its corresponding pair of transfer gate transistors (e.g. $QY_{11}$, $QY_{12}$) are made conductive.

While in the test mode, the signal TE is at a high active level and the transistors $QT_0$ to $QT_3$ are all conductive to make A0', A1', $\overline{\text{A0}}$ and $\overline{\text{A1}}$ the low level. Thus, all the NOR gates NG1 to NG4 produce the high level outputs so that all the transfer gate transistors $QY_{11}$ -$QY_{42}$ are conductive.

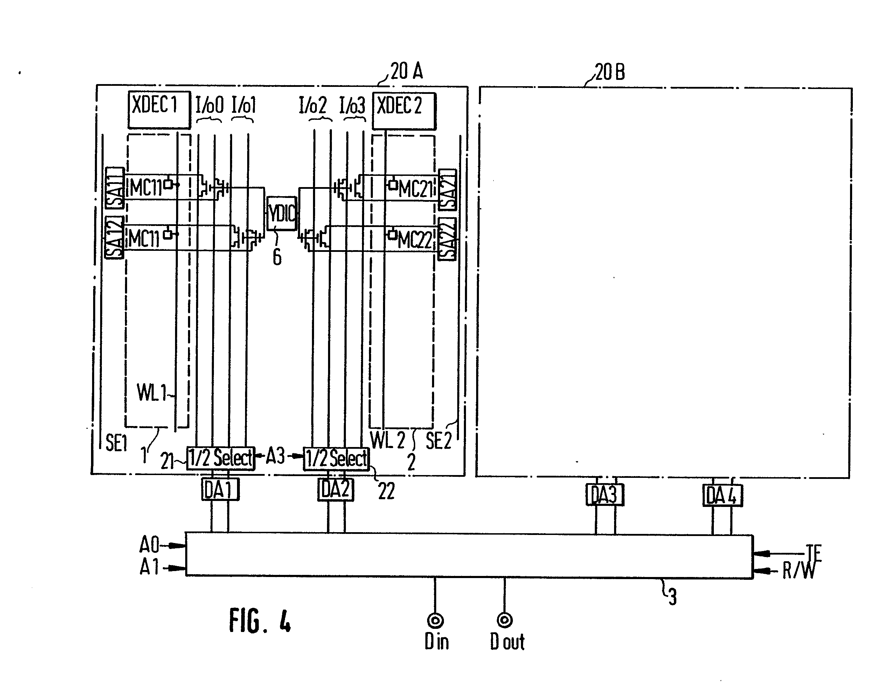

Referring to Fig. 4, a memory device according to another embodiment of the present invention is explained.

The memory device includes two memory arrays 20A and 20B each of which is basically the same as the memory of Fig. 1 except that a bus line selectors 21 and 22 are provided.

The bus line selector 21 selectively connects one of two bus line pairs I/O 0 and I/O 1 to the amplifier DA1 in response to content of an address signal A3. The bus line selecter 22 similarly selects one of two bus line pairs I/O 2 and I/O 3 for connection to the amplifier DA2 in response to A3. Therefore, the unit of column decoder 6 first selects two bit line pairs in the block 1 and two bit line pairs in the block 2 and the selecter 21 selects one bit line pair in the block 1 finally and the selecter 22 also selects one bit line pair in the block 2. The array 20B has the same structure as the array 20A. Thus, in the test mode, only one pair of bit lines are selected in each of memory blocks, and the same effect and advantages can be achieved in this embodiment as those in the previous embodiment.

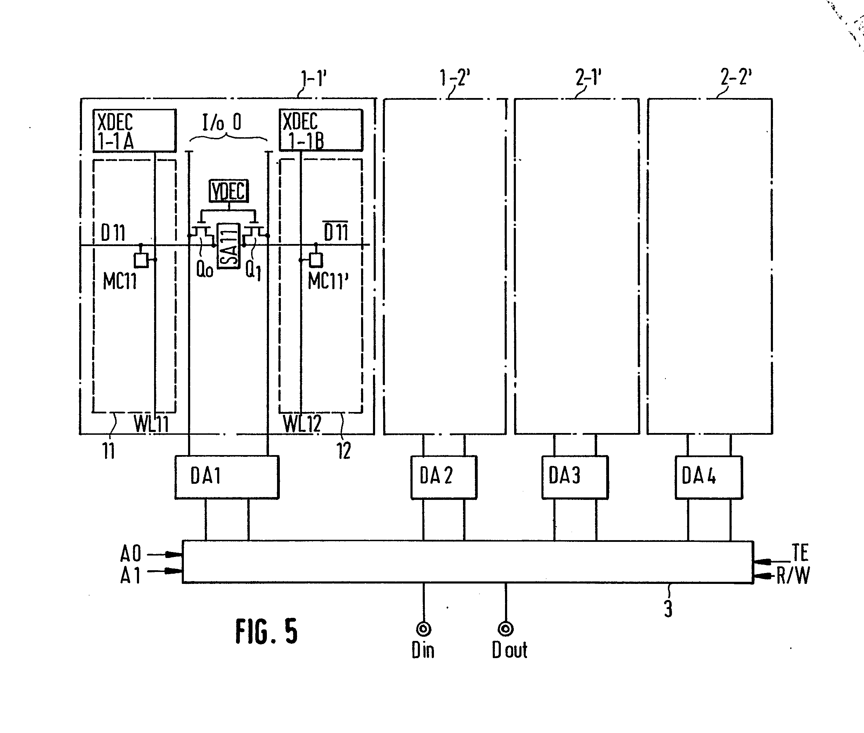

Referring to Fig. 5, a memory device according to a third embodiment.

This embodiment is electrically the same as that of Fig. 2, but is different in the arrangement of memory cells.

Namely, the memory blocks 1-1', 1-2', 2-1' and 2-2' of Fig. 5 correspond to the blocks 1-1, 1-2, 2-1 and 2-2 in Fig. 2, respectively. However, in each blocks e.g. 1-1' in Fig. 5, the sense amplifiers (e.g. SA11) are arranged along the center axis between two sub-blocks 11 and 12 as shown in the block 1-1' according to the known open-bit line structure. Namely, the block 1-1 in Fig. 2 is divided into two sub-blocks 11 and 12. It is apparent that the embodiment of Fig. 5 achieves the same effect as the previous embodiments.

## Claims

1. A semiconductor memory device comprising first and second memory cell blocks arranged separately, each of said first and second memory cell blocks including a plurality of memory cells, first means for operatively accessing one memory cell of said first and second memory cell blocks in a normal operation mode, and second means for operatively accessing one memory cell of said first memory cell block and one memory cell of said second memory cell block simultaneously in a test mode.

2. The memory device according to claim 1, in which each memory cell of said first and second memory cell blocks includes a field effect transistor and a storage capacitor.

3. The memory device according to Claim 1, in which each of said first and second memory cell blocks includes a plurality of word lines arranged in rows and a plurality pairs of bit lines arranged in columns.

4. A semiconductor memory device comprising a plurality of separated memory cell blocks each including a plurality of memory cells, a plurality of selection circuits each provided for each of said memory cell blocks and operatively selecting one memory cell of the memory cell block, a data input circuit having an input receiving a data signal and an output for operatively generating a write data signal, means for receiving a control signal having first and second levels, and a control circuit for applying said write data signal to one of said selection circuits in response to the first level of said control signal and to a plurality of said selection circuits in response to the second level of said control signal.

5. The memory device according to claim 4, in which each of said memory cells includes a storage capacitor, and one ends of the storage capacitors of the memory cells of each of said memory cell block are formed commonly by a single conductive plate.

FIG.1 prior Art

FIG. 2

0 267 587

FIG. 3

0 267 587

FIG. 4

FIG. 5

0 267 587